# EUROPÄISCHE PATENTSCHRIFT

(11) **EP 2 026 373 B1**
(45) Veröffentlichungstag und Bekanntmachung des Hinweises auf die Patenterteilung: **17.02.2010**
(21) Anmeldenummer: 07015469.5
(22) Anmeldetag: 07.08.2007
(51) Int. Cl.: H01J 37/02

(54) **Positioniereinrichtung zum Positionieren einer Blende in einem lonenstrahl**
Positioning device for positioning an aperture in an ion beam
Dispositif de positionnement destiné au positionnement d'un diaphragme dans un rayon d'ions

(43) Veröffentlichungstag der Anmeldung: 18.02.2009
(73) Patentinhaber: Micronas GmbH, 79108 Freiburg i. Br. (DE)
(72) Erfinder: Kienlen, Gabriel, 68000 Houssen (FR)
(74) Vertreter: Huwer, Andreas

(56) Entgegenhaltungen:
- EP-A- 0 690 475
- WO-A-90/09559
- US-A- 5 671 057
- US-A1- 2003 217 474
- US-A1- 2005 056 794

## Beschreibung

Die Erfindung betrifft eine Positioniereinrichtung zum Positionieren einer Blende in einem lohenstrahl einer Ionen-Implantationsanlage, wobei die Positioniereinrichtung zwei mittels mindestens eines Positionierantriebs relativ zueinander verstellbare Vorrichtungsteile hat, von denen das eine mit einer ortsfest zu einer lonenstrahlquelle angeordneten Widerlagerstelle und das andere mit der Blende verbindbar oder verbunden ist, wobei eine Justiereinrichtung mit einer Verstelleinrichtung und einer Anzeigeeinrichtung vorgesehen ist, wobei mittels der Verstelleinrichtung die Position mindestens eines der Vorrichtungsteile relativ zu dem Positionierantrieb veränderbar ist, wobei mittels der Anzeigeeinrichtung überprüfbar ist, ob sich die Vorrichtungsteile in einer vorbestimmten Lage relativ zueinander befinden, und wobei die Anzeigeeinrichtung an dem ersten Vorrichtungsteil oder einem fest damit verbundenen Teil mindestens eine Referenzmarke aufweist.

Eine derartige, auch als Manipulator bezeichnete Positioniereinrichtung ist aus der Praxis bekannt und wird von der Firma Varian Semiconductor Equipment Associates, Inc., Gloucester, Massachusetts, USA vertrieben. Die Positioniereinrichtung wird für die Herstellung von Halbleiterchips verwendet, um einen von einer lonenquelle erzeugten Ionenstrahl entlang einer vorbestimmten Bahnkurve auszurichten und auf einen Wafer zu projizieren. Die Positioniereinrichtung hat zu diesem Zweck eine im Strahlengang des lonenstrahls angeordnete Graphit-Blende, deren Blendenöffnung kleiner ist als der Durchmesser des lonenstrahls. Die Blende ist lösbar mit einer Elektrodenplatte verbunden. An der Elektrodenplatte liegt eine elektrische Spannung an, die dazu dient, eine möglichst große Anzahl von Ionen durch die Öffnung der Blende hindurchzuleiten.

Zum Positionieren der Blende in dem lonenstrahl hat die Positioniereinrichtung zwei verstellbare Vorrichtungsteile, von denen ein erstes Vorrichtungsteil mit einer ortsfest zu der lonenstrohlquelle angeordneten Widerlagerstelle und ein zweites Vorrichtungsteil über eine Masseplatte mit der Elektrodenplatte elektrisch isolierend verbunden ist. Das zweite Vorrichtungsteil ist zusammen mit der daran angeordneten Masseplatte, der Elektrodenplatte und der Blende mit Hilfe von elektrischen Positionierantrieben in X-, Y- und Z-Richtung relativ zum lonenstrahl positionierbar.

Jedem Positionierantrieb ist jeweils ein Lagesensor zugeordnet, der ein Lagemesssignal für die dem Positionierantrieb zugeordnete Achse bereitstellt. Die Ansteuerung der Positionierantriebe erfolgt über Lageregler, die jeweils einen Eingang für ein Sollwertsignal und einen Eingang für das Lagesensorsignal des dem entsprechenden Positionierantrieb zugeordneten Lagesensors aufweisen. Bei einer Abweichung zwischen dem Sollwertsignal und dem Lagesensorsignal wird die Positionierung der Blende mit Hilfe des Lagereglers im Sinne einer Reduzierung der Abweichung verändert.

Vor der ersten Inbetriebnahme der Positioniereinrichtung sowie nach jeder Wartung, bei der die Positioniereinrichtung beispielsweise zum Reinigen der Blende, der Masseplatte und der Elektrodenplatte zerlegt wurde, wird die aus der lonen-Implantationsanlage ausgebaute Positioniereinrichtung zunächst mit Hilfe einer Anzeigeeinrichtung justiert. Während der Justage müssen sich die Positionierantriebe in einer vorbestimmten Referenzlage befinden. Die Positionierantriebe werden deshalb von Beginn der Wartungsarbeiten bei mit der Ionen-Implantationsanlage verbundener Positioniereinrichtung elektrisch in die Referenzlage gefahren.

Die Anzeigeeinrichtung weist ein erstes, etwa kreissscheibenförmiges und ein zweites, etwa quaderförmiges Anzeigenteil auf. Das zweite Anzeigenteil hat eine zu dem ersten Teil passende kreisrunde Öffnung. An beiden Anzeigenteilen sind Markierungslinien angeordnet. Das erste Anzeigenteil wird anstelle der Masseplatte an dem zweiten Vorrichtungsteil montiert und das zweite Anzeigenteil wird an einem ortsfesten Gehäuse der Positioniereinrichtung angeschraubt. Dabei ist das kreissscheibenförmige erste Teil in der Öffnung des zweiten Teils angeordnet oder axial etwas von dieser beabstandet.

Dann werden die Antriebsverbindungen zwischen den Positionierantrieben und dem zweiten Vorrichtungsteil durch Lösen von Schrauben unterbrochen und das zweite Vorrichtungsteil wird manuell derart relativ zu dem ersten Vorrichtungsteil ausgerichtet, dass die der X- und Y-Achse zugeordneten Markierungslinien des ersten Anzeigenteils mit den entsprechenden Markierungslinien des zweiten Anzeigenteils fluchten und außerdem das kreisscheibenförmige zweite Anzeigenteil in der von der Öffnung des ersten Anzeigenteils aufgespannten Eben angeordnet ist. Danach werden die Schrauben wieder angezogen, um die Antriebsverbindungen zwischen den Positionierantrieben und dem zweiten Vorrichtungsteil wieder herzustellen. Dann wird die Anzeigeeinrichtung demontiert und es werden die Masseplatte und die Elektrodenplatte mit dem zweiten Vorrichtungsteil verschraubt, um danach die Blende an der Elektrodenplatte zu montieren.

Die Positioniereinrichtung hat jedoch den Nachteil, dass beim manuellen Justieren der Vorrichtungsteile leicht Positionierungsfehler auftreten können. Außerdem können bei der Montage der Masseplatte und der Elektrodenplatte Spiel zwischen dem zweiten Vorrichtungsteil und der Masseplatte einerseits sowie zwischen der Masseplatte und der Elektrodenplatte andererseits auftreten, so dass die Blende dann nicht mehr in der richtigen Lage relativ zu dem zweiten Vorrichtungsteil angeordnet ist. Derartige Positionierungstoleranzen der Blende verursachen während der Ionenimplantation ein Abweichen des lonenstrahls von seiner vorgesehenen Bahnkurve, mit der Folge, dass sich der auf den Wafer auftreffende lonenstrom reduziert. Um Fertigungstoleranzen der Wafer zu reduzieren, wird der lonenstrom gemessen und die Bestrahlungsdauer in Abhängigkeit von dem lonenstrom angepasst. Daher führen Fehlpositionierungen der Blende zu einer Verlängerung der Implantationszeit und damit zu einer geringeren Produktivität sowie entsprechend erhöhten Produktionskosten. Ungünstig ist außerdem, dass ein zu geringer lonenstrom die für das Feintuning der Positioniereinrichtung benötigte Zeit erhöht, wodurch zusätzliche Produktionszeit verloren geht.

Es besteht deshalb die Aufgabe, eine Positioniereinrichtung der eingangs genannten Art zu schaffen, die es auf einfache Weise ermöglicht, die Blende in einer vorbestimmten Lage relativ zu dem ersten Vorrichtungsteil anzuordnen.

Diese Aufgabe wird dadurch gelöst, dass die Anzeigeeinrichtung an dem zweiten Vorrichtungsteil mindestens eine optische Projektionseinrichtung aufweist, mittels der auf das erste Vorrichtungsteil wenigstens eine optische Markierung projizierbar ist, die der mindestens einen Referenzmarke zugeordnet ist.

Dabei ist die optische Projektionseinrichtung bevorzugt derart ausgestaltet und an dem zweiten Vorrichtungsteil angeordnet, dass die mit Hilfe der Projektionseinrichtung projizierte Markierung in einer vorbestimmten Referenzlage mit der Referenzmarke zur Deckung kommt. Der die optische Markierung erzeugende Lichtzeiger ermöglicht dabei eine sehr genaue Positionierung der Vorrichtungsteile.

Bei einer bevorzugten Ausgestaltung der Erfindung ist die Blende lösbar mit einer an dem zweiten Vorrichtungsteil vorgesehenen Aufnahme verbindbar, und die Projektionseinrichtung ist derart ausgestaltet, dass sie anstelle der Blende mit der Aufnahme verbindbar ist. Eventuelle Positionierungstoleranzen der Aufnahme, die durch Fertigungs- und/oder Montagetoleranzen verursacht sein können, werden dann bei der Justage berücksichtigt und können durch entsprechendes Positionieren des zweiten Vorrichtungsteils relativ zu dem ersten Vorrichtungsteil kompensiert werden.

Vorteilhaft ist, wenn die Aufnahme mindestens eine Führungsschiene vorzugsweise für eine Schwalbenschwanzführung aufweist, und wenn die Blende und die Projektionseinrichtung an einem zu der Führungsschiene passenden, auf die Führungsschiene aufsteckbaren und von dieser abziehbaren Schlittenteil angeordnet oder als ein solches Schlittenteil ausgestaltet sind. Die Blende kann dann zur Justierung der Positioniereinrichtung auf einfache Weise von den Führungsschienen abgezogen und durch die Projektionseinrichtung ersetzt werden. Nach Beendigung der Justage wird in entsprechender Weise die Projektionseinrichtung von der Führungsschiene abgezogen und durch die Blende ersetzt. Die Projektionseinrichtung lässt sich dadurch mit großer Präzision an der Aufnahme montieren.

Bei einer zweckmäßigen Ausgestaltung der Erfindung ist die Projektionseinrichtung zur Projektion von mindestens zwei quer zueinander angeordneten, vorzugsweise sich kreuzenden durchgehenden und/oder unterbrochenen Linien ausgestaltet, wobei eine erste Linie etwa parallel zu einer ersten Achse der Positioniereinrichtung und eine zweite Linie etwa parallel zu einer zweiten Achse der Positioniereinrichtung verläuft, und wobei der ersten Linie an dem ersten Vorrichtungsteil vorzugsweise mindestens eine erste Referenzmarke und der zweiten Linie vorzugsweise mindestens eine zweite Referenzmarke zugeordnet ist. Somit können mit einer mit nur einem einzigen Projektor erzeugten optischen Markierung zwei Achsen justiert werden.

Bei einer bevorzugten Ausführungsform der Erfindung weist die Positioniereinrichtung mindestens eine dritte Achse auf, die quer und insbesondere orthogonal zur ersten Achse und zur zweiten Achse verläuft, wobei die Projektionseinrichtung zur Projektion einer dritten Linie ausgestaltet ist, die parallel zu der dritten Achse verläuft, und wobei der dritten Linie an dem ersten Vorrichtungsteil vorzugsweise mindestens eine dritte Referenzmarke zugeordnet ist. Somit können mit Hilfe der optischen Anzeigeeinrichtung alle drei Achsen der Positioniereinrichtung auf ihre korrekte Einstellung überprüft werden.

Bei einer vorteilhafften Ausgestaltung der Erfindung ist die Aufnahme lösbar mit dem zweiten Vorrichtungsteil verbunden und vorzugsweise an einer elektrisch gegen das zweite Vorrichtungsteil isolierten Elektrodenplatte angeordnet, die eine Durchgangslochung für den lonenstrahl aufweist. Das die Aufnahme aufweisende Teil kann dann bei Wartungsarbeiten von den Positionierantrieben demontiert und leicht gereinigt werden. An die Elektrodenplatte kann während des Implantationsvorganges eine elektrische Spannung angelegt werden, die das Hindurchtreten des lonenstrahls durch die Blende unterstützt.

Besonders vorteilhaft ist, wenn die mindestens eine Referenzmarke an einem lösbar mit dem ersten Vorrichtungsteil verbindbaren Trägerteil angeordnet ist, und wenn das Trägerteil derart ausgestaltet ist, dass es mit dem ersten Vorrichtungsteil verbindbar und von diesem trennbar ist, während die Elektrodenplatte an dem ersten Vorrichtungsteil montiert ist. Somit kann die Einstellung der einzelnen Achsen der Positioniereinrichtung ohne eine Demontage der Elektrodenplatte überprüft werden. Die Achsen können dadurch noch genauer justiert werden.

Zweckmäßigerweise ist zur Ansteuerung des mindestens eines Positionierantriebs eine mobile Ansteuereinrichtung vorgesehen, die über eine elektrische Steckverbindung lösbar mit dem mindestens einen Positionierantrieb verbindbar ist, wobei die Ansteuereinrichtung mindestens ein Betätigungselement für den Positionierantrieb aufweist. Die Achsen können dann bei von der Ionen-Implantationsanlage demontierter Positioniereinrichtung auf einfache Weise zum mechanischen Nullabgleich mit Hilfe der mobilen Ansteuereinrichtung elektrisch positioniert werden.

Vorteilhaft ist, wenn die Positioniereinrichtung zur Erfassung der Position des mindestens einen Positionierantriebs wenigstens einen Lagesensor aufweist, und wenn die Ansteuereinrichtung mindestens eine damit verbundene Positionsanzeige hat. Die Positioniereinrichtung kann dann mit ihrer Nulllage sowohl mechanisch als auch elektrisch in eine vorbestimmte Referenzlage justiert werden. Der Lagesensor kann ein Potentiometer und/oder einen Encoder aufweisen.

Die erfindungsgemäße Positioniereinrichtung kann ein Teil einer lonen-Implantationsanlage sein, wobei die Positioniereinrichtung wenigstens einen Lagesensor mit einem Ausgang für ein erstes Lagemesssignal aufweist, der über eine Kompensationseinrichtung und einen Lageregler mit dem mindestens einen Positionierantrieb verbunden ist, wobei die Kompensationseinrichtung einen mit dem Lagesensor verbundenen Eingang für das erste Lagemesssignal und einen mit einem Istwerteingang des Lagereglers verbundenen Ausgang für ein zweites Lagemesssignal hat, und wobei die Kompensationseinrichtung derart ausgestaltet ist, dass sie das zweite Lagemesssignal in Abhängigkeit von dem ersten Lagemesssignal und mindestens einem die Bahnkurve des lonenstrahls beeinflussenden maschinenspezifischen Parameter der Ionen-Implantationsanlage bereitstellt. In vorteilhafter Weise ermöglicht es die Kompensationseinrichtung, durch maschinenspezifische Toleranzen verursachte Abweichungen der Bahnkurve des lonenstrahls von einer Solllinie elektrisch zu kompensieren. In einer Fabrik, die mehrere Implantationsanlagen aufweist, kann dann die Positioniereinrichtung einer Implantationsanlage gegen die die Positioniereinrichtung einer anderen Implantationsanlage ausgetauscht werden, ohne dass sich bei den Implantationsanlagen zwischen der Blende und einem zu bestrahlenden Wafer der Verlauf der Bahnkurve verändert.

Vorteilhaft ist, wenn der wenigstens eine Lagesensor über eine Steckkupplung mit dem Lageregler verbunden ist, wenn die Steckkupplung ein erstes Steckkupplungsteil und ein dazu passendes zweites Steckkupplungsteil aufweist, und wenn die Kompensationseinrichtung als zwischen die Steckkupplungsteile einsetzbarer Adapter ausgestaltet ist, der ein mit dem ersten Steckkupplungsteil verbindbares drittes Steckkupplungsteil und ein mit dem zweiten Steckkupplungsteil verbindbares viertes Steckkupplungsteil aufweist. Dadurch ist es insbesondere möglich, eine vorhandene Ionen-Implantationsanlage mit der Kompensationseinrichtung nachzurüsten, in dem diese auf einfache weise zwischen die Steckkupplungsteile der Implantationsanlage eingesetzt wird.

Zweckmäßigerweise hat die Kompensationseinrichtung mindestens ein Stellelement, mittels dem die Übertragungsfunktion zwischen dem ersten und dem zweiten Lagemesssignal einstellbar ist. Somit kann die Kompensationseinrichtung auf einfache Weise an die jeweiligen individuellen Eigenschaften der lonen-Implantationsanlage angepasst werden.

Nachfolgend ist ein Ausführungsbeispiel der Erfindung anhand der Zeichnung näher erläutert. Es zeigt:
- Fig. 1: eine schematische Darstellung einer Ionen-Implantationsanlage, die eine lonenstrahlquelle, eine Positioniereinrichtung zum Positionieren einer Blende im lonenstrahl und eine Strahlführung für den lonenstrahl auf- weist,
- Fig. 2: eine Teilansicht der Positioniereinrichtung, auf der die Blende erkennbar ist,
- Fig. 3: eine Darstellung ähnlich Fig. 2, wobei jedoch die Blende durch eine optische Projektionseinrichtung ersetzt und an einem ersten Vorrich- tungsteil der Positioniereinrichtung ein Trägerteil mit Referenzmarken montiert ist,
- Fig. 4 und 5: Seitenansichten des Trägerteils,
- Fig. 6: eine mobile Ansteuereinrichtung für die Positionierantriebe der Positio- niereinrichtung,
- Fig. 7: eine graphische Darstellung der Lagemesssignale für die X-Achsen von vier baugleichen, Toleranzen aufweisende Ionen-Implantationsanlagen, wobei auf der Abszisse das normierte Lagemesssignal und auf der Ordi- nate der Positionierweg aufgetragen ist, und wobei strichliniert eine Sollli- nie markiert ist,
- Fig.8: eine graphische Darstellung der lonenströme der lonen- Implantationsanlagen, wobei auf der Abszisse das normierte Lagemess- signal und auf der Ordinate der lonenstrom in µA aufgetragen ist,
- Fig. 9: ein elektrisches Ersatzschaltbild, welches die Positioniereinrichtung, eine Kompensationseinrichtung und einen Steuercomputer der lonen- Implantationsanlage zeigt, und
- Fig. 10: eine als Adapter ausgestaltete Kompensationseinrichtung zur Kompen- sation von Toleranzen der Strahlführung.

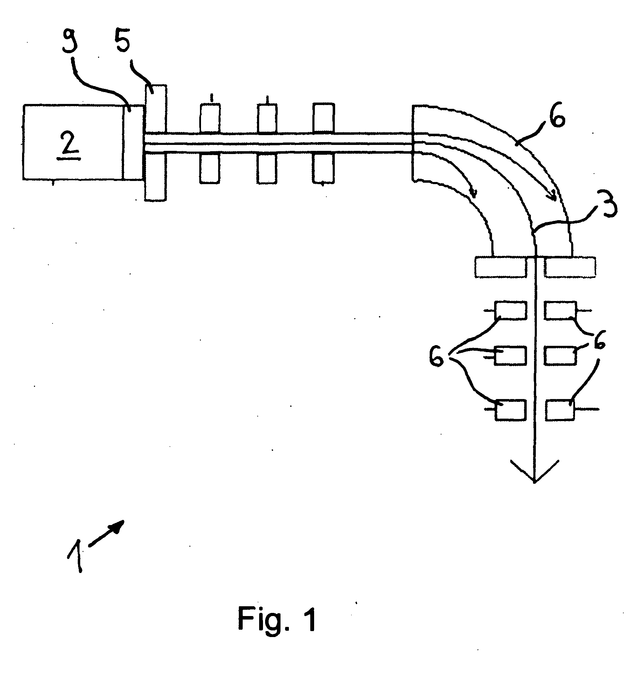

Eine in Fig. 1 im Ganzen mit 1 bezeichnete Ionen-Implantationsanlage weist eine lonenstrahlquelle 2 zum Erzeugen eines lonenstrahls 3, eine im lonenstrahl 3 angeordnete Blende 4, eine Positioniereinrichtung 5 zum Positionieren der Blende 4 in dem Ionenstrahl 3 und eine zwischen der Blende 4 und einem zu bestrahlenden Halbleiterwafer angeordnete Strahlführung 6 auf. Die Blende 4 hat eine etwa schlitzförmige Blendenöffnung und besteht aus einem für den Ionenstrahl undurchlässigen Werkstoff, beispielsweise aus Graphit.

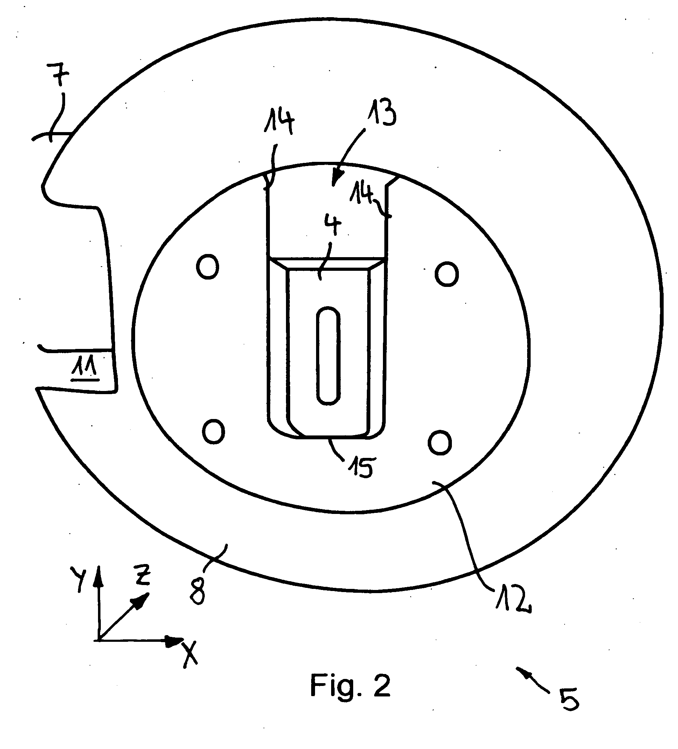

Die Positioniereinrichtung 5 weist zwei relativ zueinander bewegbare, in Fig. 2 näher dargestellte Vorrichtungsteile 7, 8 auf, von denen ein erstes Vorrichtungsteil 7 lösbar mit einer ortsfest zur lonenstrahlquelle 2 angeordneten Widerlagerstelle 9 und ein zweites Vorrichtungsteil 8 lösbar mit einem in der Zeichnung nicht näher dargestellten Positionierelement verbunden ist. Das Positionierelement ist mittels elektrischer Positionierantriebe 10a, 10b, 10c dreiachsig in X-, Y- und Z-Richtung relativ zu dem ersten Vorrichtungsteil 7 positionierbar.

Das zweite Vorrichtungsteil 8 ist im Wesentlichen ringscheibenförmig mit einer etwa kreisrunden Lochung ausgestaltet. An ihrer den Positionierantrieben 10a, 10b, 10c zugewandten Außenseite hat das zweite Vorrichtungsteil 8 eine randoffene Aussparung 11.

Mit dem zweiten Vorrichtungsteil 8 ist eine Elektrodenplatte 12 lösbar verbunden, die durch eine elektrische Isolierung von dem zweiten Vorrichtungsteil 8 beabstandet ist. Die Elektrodenplatte hat eine Durchgangslochung für den lonenstrahl, die in Fig. 2 hinter der Blende 4 angeordnet ist. Zwischen dem zweiten Vorrichtungsteil 8 und der Elektrodenplatte 12 ist eine elektrische Spannung anlegbar.

An dem zweiten Vorrichtungsteil 8 ist eine Aufnahme 13 vorgesehen, die beidseits der Längsmittelachse der kreisrunden Lochung des zweiten Vorrichtungsteils 8 angeordnete, parallel zueinander verlaufende Führungsschienen 14 aufweist. Die Blende 4 ist als Schlittenteil ausgestaltet, das auf die Führungsschienen 14 aufsteckbar und derart gegen einen Anschlag 15 positionierbar, dass die Blende 4 die kreisrunde Lochung des zweiten Vorrichtungsteils 8 überdeckt. Zum Trennen der Blende 4 von dem zweiten Vorrichtungsteil 8 kann diese von den Führungsschienen 14 abgezogen werden.

Die Positioniereinrichtung 5 hat ferner ein in der Zeichnung nicht näher dargestellte Verstelleinrichtung, mittels der in einer vorbestimmten Referenzlage der Positionierantriebe 10a, 10b, 10c die Antriebsverbindung zwischen den Positionierantrieben 10a, 10b, 10c und dem zweiten Vorrichtungsteil 8 vorübergehend unterbrochen werden kann, um die Nulllage der Positioniereinrichtung 5 einstellen.

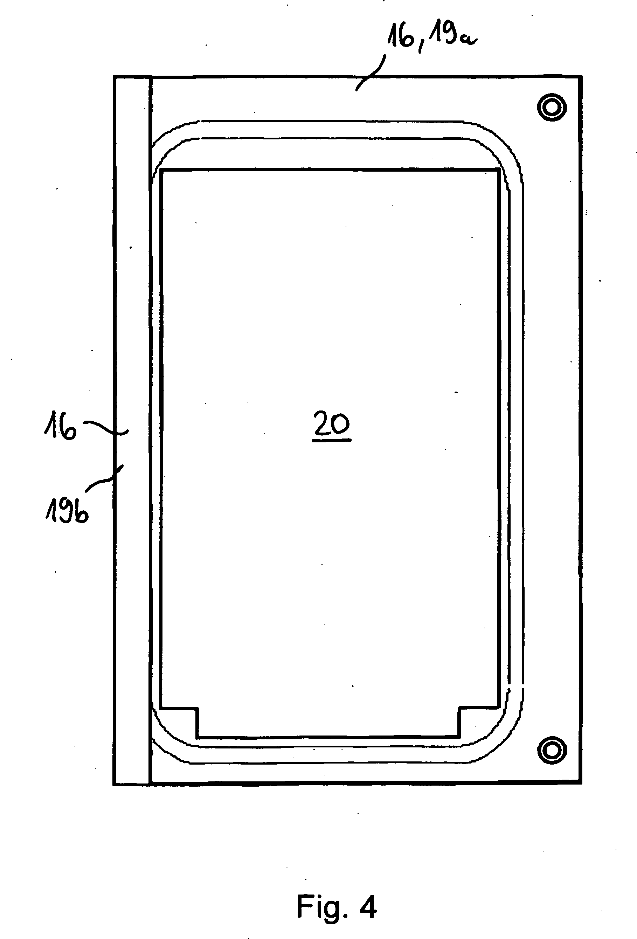

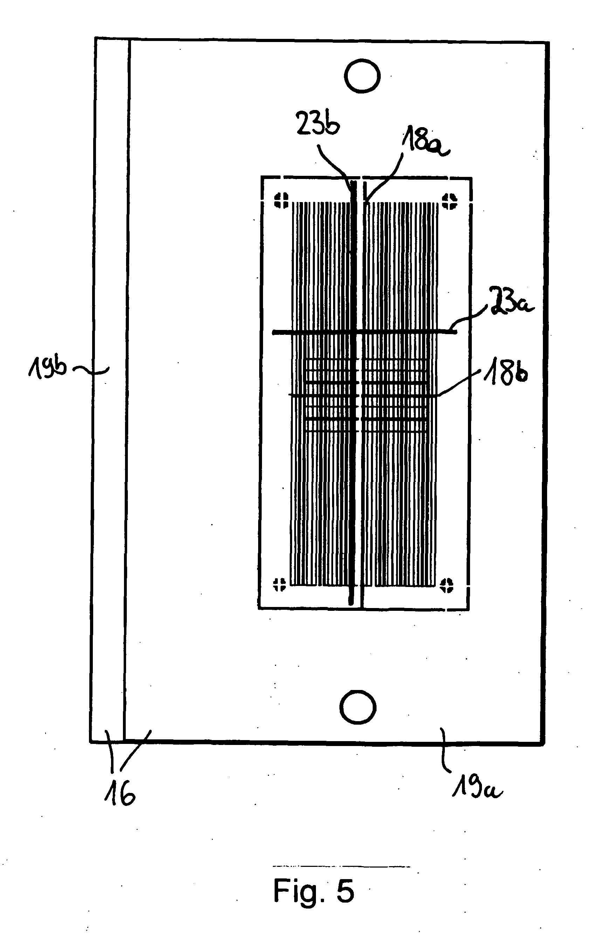

Zur Überprüfung der Nulllage der Vorrichtungsteile 7, 8 hat die Positioniereinrichtung 5 eine Anzeigeeinrichtung, die ein Trägerteil 16 und eine Projektionseinrichtung 17 aufweist. Das Trägerteil 16 ist in einer definierten Lage zu dem ersten Vorrichtungsteil 7 lösbar mit diesem verbindbar. An dem Trägerteil 16 sind Skalen angebracht, die Referenzmarken 18a, 18b, 18c aufweisen. Die Referenzmarken 18a sind der X-Achse, die Referenzmarken 18b der Y-Achse und die Referenzmarken 18c der Z-Achse der Positioniereinrichtung 17 zugeordnet. In Fig. 4 und 5 ist erkennbar, dass das Trägerteil 16 zwei Plattenteile 19a, 19b aufweist, von denen das eine rahmenförmig mit einer Öffnung 20 ausgestaltet ist. Die Öffnung 20 ist derart dimensioniert, dass das Trägerteil 16 mit der Öffnung 20 auf das zweite Vorrichtungsteil 8 aufgesteckt werden kann, wenn dieses mit dem ersten Vorrichtungsteil 7 verbunden ist.

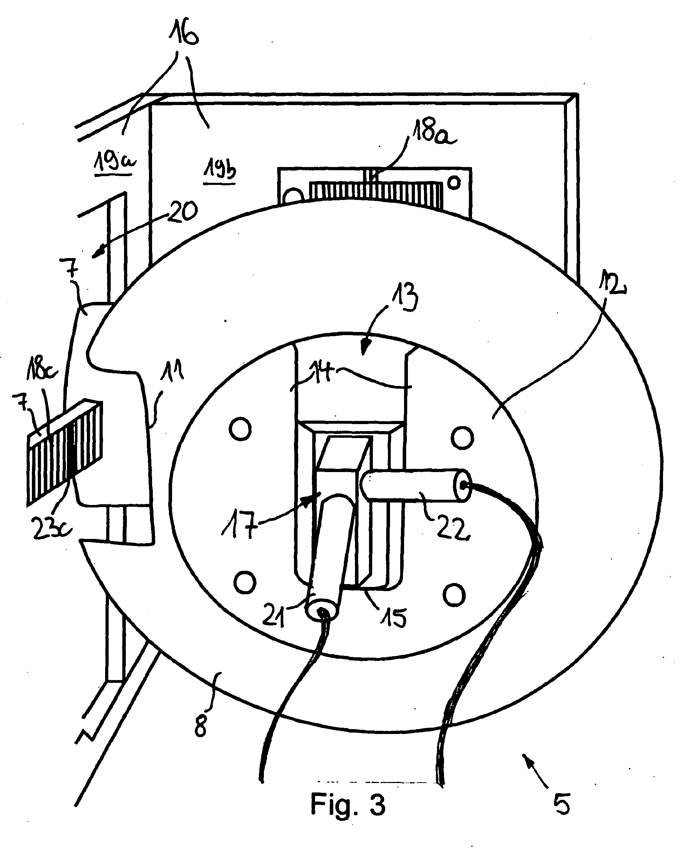

Wie in Fig. 3 erkennbar ist, ist die Projektionseinrichtung 17 als zu den Führungsschienen 14 passendes Schlittenteil ausgestaltet, das anstelle der Blende 4 in die Aufnahme 13 einsetzbar ist. Die Projektionseinrichtung 17 hat einen Kreuzlinienprojektor 21 und einen Einzellinienprojektor 22, die mit ihren Hauptabstrahlrichtungen orthogonal zueinander angeordnet und von den Referenzmarken 18a, 18b, 18c beabstandet sind. Mit dem Kreuzlinienprojektor 21 können eine quer zur X-Achse verlaufende erste optische Linie 23a und eine diese unter einem Winkel von etwa 90° kreuzende zweite optische Linie 23b auf die Referenzmarken 18a, 18b projiziert werden. Mit dem Einzellinienprojektor 22 kann eine quer zur Z-Achse verlaufende dritte optische Linie 23c auf die Referenzmarken 1 8c projiziert werden.

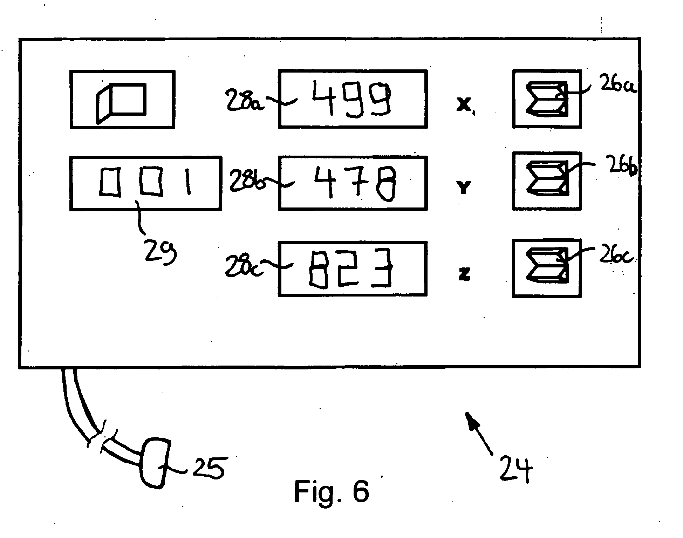

Zur Ansteuerung der Positionierantriebe 10a, 10b, 10c bei von der Widerlagerstelle 9 demontierter Positioniereinrichtung 5 ist eine mobile Ansteuereinrichtung 24 (Fig. 6) vorgesehen, die über eine elektrische Steckverbindung 25 lösbar mit den Positionierantrieben 1 0a, 10b, 10c verbindbar ist. Die Ansteuereinrichtung 24 hat für jeden Positionierantrieb 10a, 10b, 1 0c jeweils ein Betätigungselement 26a, 26b, 26c, mittels dem der betreffende Positionierantrieb 10a, 10b, 10c in Vorwärts- und Rückwärtsrichtung bewegbar ist.

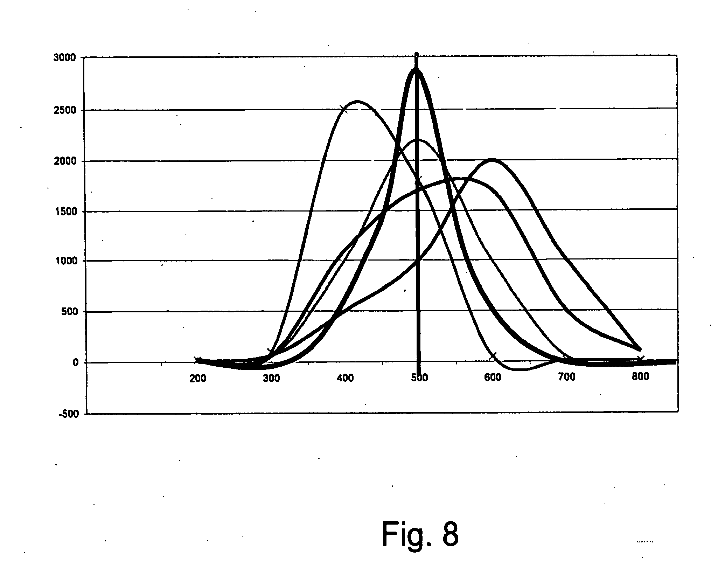

Zur Erfassung der Position der einzelnen Positionierantriebe 10a, 10b, 10c ist jedem Positionierantrieb 10a, 10b, 10c jeweils ein Lagesensor 27a, 27b, 27c zugeordnet, der bei dem Ausführungsbeispiel gemäß Fig. 8 ein mit dem Positionierantrieb 10a, 10b, 10c in Antriebsverbindung stehendes Potentiometer aufweist. Jeder Lagesensor 27a, 27b, 27c ist jeweils über die Steckverbindung 25 elektrisch mit einer ihm zugeordneten Positionsanzeige 28a, 28b, 28c verbunden, die an der mobilen Ansteuereinrichtung 24 angeordnet und vorzugsweise als Digitalanzeige ausgestaltet ist. Die Ansteuereinrichtung 24 weist außerdem eine Anzeige 29 für die Stromaufnahme der Positionierantriebe 10a, 10b, 10c auf. Mit Hilfe dieser Anzeige 29 lassen sich Schwergängigkeiten in der Mechanik, die zu einer erhöhten Stromaufnahme der Positionierantriebe 10a, 10b, 10c führen, erkennen.

Zur Justierung der Achsen wird die Anzeigeeinrichtung an der aus der lonen-Implantationsanlage 1 ausgebauten Positioniereinrichtung 5 montiert, indem das Trägerteil 16 mit dem ersten Vorrichtungsteil 7 verbunden und die Blende 4 durch die Projektionseinrichtung 17 ersetzt wird. Dann wird die Ansteuereinrichtung 24 an der Positioniereinrichtung 5 angeschlossen, um die Achsen so zu positionieren, dass an den Positionsanzeigen 28a, 28b, 28c jeweils ein der betreffenden Achse zugeordneter Referenzwert angezeigt wird.

Dann wird die Antriebsverbindung zwischen den Positionierantrieben 10a, 10b, 10c und dem zweiten Vorrichtungsteil 8 unterbrochen, um die Vorrichtungsteile 7, 8 derart relativ zueinander zu positionieren, dass die optischen Linien 23a, 23b, 23c jeweils in einer durch die Referenzmarken 18a, 18b, 18c angezeigten Position angeordnet sind. Danach wird die Antriebsverbindung zwischen den Positionierantrieben 10a, 10b, 10c und dem zweiten Vorrichtungsteil 8 wieder hergestellt.

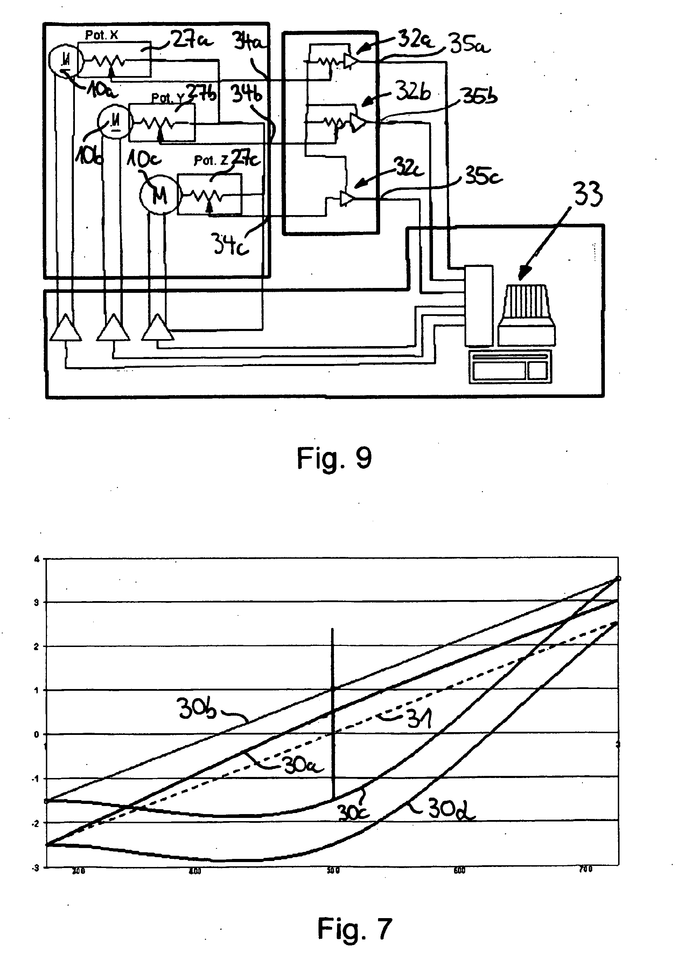

Eine in der Zeichnung nicht näher dargestellte Halbleitertertigungsanlage weist mehrere, im Wesentlichen baugleiche Ionen-Implantationsanlagen 1 auf. Anhand der Kennlinien 30a, 30b, 30c, 30d in Fig. 9 ist erkennbar, dass die lonen-Implantationsanlagen 1 Toleranzen aufweisen. Werden diese Toleranzen nicht kompensiert, verlaufen die lonenstrahlen 3 bei gleicher Positionierung der Blende 4 entlang unterschiedlicher, von einer Solllinie 31 abweichender Bahnkurven. Dadurch ergeben sich bei den einzelnen Implantationsanlagen 1 bei gleicher Blendenpositionierung unterschiedliche Lagemesssignale.

In Fig. 8 ist erkennbar, dass aufgrund der unterschiedlichen Bahnkurven der lonenstrahlen 3 an den mit den einzelnen Ionen-Implantationsanlagen 1 bestrahlten Wafern unterschiedliche lonenströme erreicht werden und dass diese lonenströme bei einer mittigen Positionierung der Blende 4 geringer sind als der lonenstrom, der erreicht würde, wenn der Ionenstrahl 3 entlang der Solllinie 31 verlaufen würde. Durch diese Reduzierung der lonenströme wird für die Bestrahlung der Wafer eine längere Zeitdauer benötigt, d.h. die Produktivität der Halbleiterfertigungsanlage reduziert sich entsprechend.

Um dies zu vermeiden, ist jedem der drei Lagesensoren 27a, 27b, 27c der einzelnen Ionen-Implantationsanlagen 1 jeweils eine Kompensationseinrichtung 32a, 32b, 32c zugeordnet, über die der betreffende Lagesensor 27a, 27b, 27c mit einem Lageregler verbunden ist, der in einen Mikrocomputer 33 integriert ist. In Fig. 9 ist erkennbar, dass jeder Lagesensor 27a, 27b, 27c jeweils einen Ausgangsanschluss 34a, 34b, 34c für ein erstes Lagemesssignal aufweist, der mit einem Eingang der ihm jeweils zugeordneten Kompensationseinrichtung 32a, 32b, 32c verbunden ist. Jede Kompensationseinrichtung 32a, 32b, 32c hat jeweils einen Ausgang 35a, 35b, 35c für ein zweites Lagemesssignal, der an einem Istwerteingang des der betreffenden Kompensationseinrichtung 32a, 32b, 32c zugeordneten Lagereglers angeschlossen ist.

Mit Hilfe der Kompensationseinrichtungen 32a, 32b, 32c werden die Toleranzen der Ionen-Implantationsanlagen 1 derart kompensiert, dass deren Kennlinie jeweils etwa der Solllinie 31 entspricht. Dadurch ist es möglich, die Positioniereinrichtungen 5 der einzelnen Ionen-Implantationsanlagen 1 untereinander auszutauschen, ohne dass sich dadurch die Bahnkurven deren lonenstrohlen verändern.

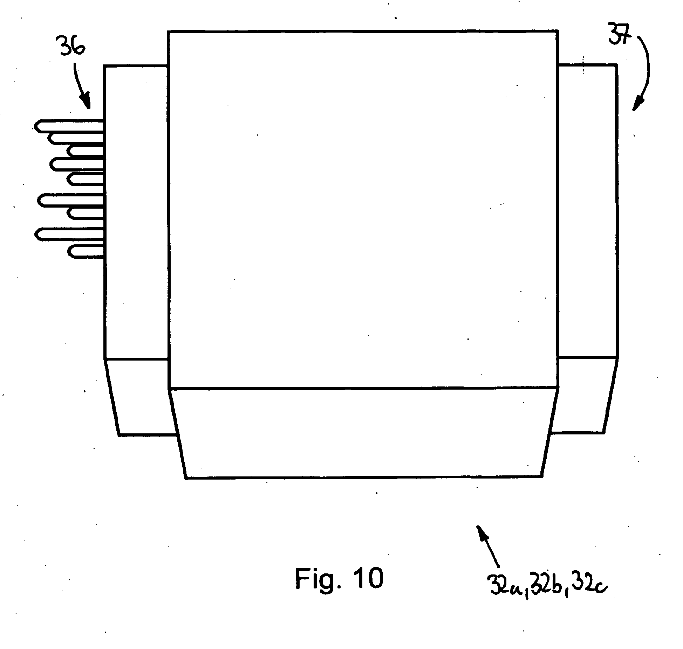

Die Lagesensoren 27a, 27b, 27c der einzelnen Ionen-Implantationsanlagen 1 sind jeweils über eine Steckkupplung mit dem Lageregler verbunden. Die Steckkupplung hat an dem Mikrocomputer 33 ein erstes Steckkupplungsteil und an der Positioniereinrichtung 5 ein dazu passendes zweites Steckkupplungsteil. Die Kompensationseinrichtungen 32a, 32b, 32c der einzelnen Ionen-Implantationsanlagen sind als Adapter ausgestaltet, der zwischen die Steckkupplungsteile einsetzbar ist. Wie in Fig. 10 erkennbar ist, hat der Adapter dazu ein mit dem ersten Steckkupplungsteil verbindbares drittes Steckkupplungsteil 36 und ein mit dem zweiten Steckkupplungsteil verbindbares viertes Steckkupplungsteil 37.

## Patentansprüche

1. Positioniereinrichtung (5) zum Positionieren einer Blende (4) in einem Ionenstrahl (3) einer Ionen-Implantaflonsanlage (1), wobei die Positioniereinrichtung (5) zwei mittels mindestens eines Positionierantriebs (10a, 10b, 10c) relativ zueinander verstellbare Vorrichtungsteile (7, 8) hat, von denen das eine mit einer ortsfest zu einer Ionenstrahlquelle angeordneten Widerlagerstelle (9) und das andere mit der Blende (4) verbindbar oder verbunden ist, wobei eine Justiereinrichtung mit einer Verstelleinrichtung und einer Anzeigeeinrichtung vorgesehen ist, wobei mittels der Verstelleinrichtung die Position mindestens eines der Vorrichtungsteile (7, 8) relativ zu dem Positionierantrieb (10a, 10b, 10c) veränderbar ist, wobei mittels der Anzeigeeinrichtung überprüfbar ist, ob sich die Vorrichtungsteile (7, 8) in einer vorbestimmten Lage relativ zueinander befinden, und wobei die Anzeigeeinrichtung an dem ersten Vorrichtungsteil (7) oder einem fest damit verbundenen Teil mindestens eine Referenzmarke (18a, 18b) aufweist, **dadurch gekennzeichnet, dass** die Anzeigeeinrichtung an dem zweiten Vorrichtungsteil (8) mindestens eine optische Projektionseinrichtung (17) aufweist, mittels der auf das erste Vorrichtungsteil (7) wenigstens eine optische Markierung projizierbar ist, die der mindestens einen Referenzmarke (18a, 18b) zugeordnet ist.

2. Positioniereinrichtung (5) nach Anspruch 1, **dadurch gekennzeichnet, dass** die Blende (4) lösbar mit einer an dem zweiten Vorrichtungsteil (8) vorgesehenen Aufnahme (13) verbindbar ist, und dass die Projektionseinrichtung (17) derart ausgestaltet ist, dass sie anstelle der Blende (4) mit der Aufnahme (13) verbindbar ist.

3. Positioniereinrichtung (5) nach Anspruch 1 oder 2, **dadurch gekennzeichnet, dass** die Aufnahme (13) mindestens eine Führungsschiene (14) vorzugsweise für eine Schwalbenschwanzführung aufweist, und dass die Blende (4) und die Projektionseinrichtung (17) an einem zu der Führungsschiene (14) passenden, auf die Führungsschiene (14) aufsteckbare und von dieser abziehbaren Schlittenteil angeordnet oder als ein solches Schlittenteil ausgestaltet sind.

4. Positioniereinrichtung (5) nach einem der Ansprüche 1 bis 3, **dadurch gekennzeichnet, dass** die Projektionseinrichtung (17) zur Projektion von mindestens zwei quer zueinander angeordneten, vorzugsweise sich kreuzenden durchgehenden und/oder unterbrochenen Linien (23a, 23b, 23c) ausgestaltet ist, dass eine erste Linie (23a) etwa parallel zu einer ersten Achse der Positioniereinrichtung (5) und eine zweite Linie (23b) etwa parallel zu einer zweiten Achse der Positioniereinrichtung (5) verläuft, und dass der ersten Linie (23a) an dem ersten Vorrichtungsteil (7) vorzugsweise mindestens eine erste Referenzmarke (18a) und der zweiten Linie (23b) vorzugsweise mindestens eine zweite Referenzmarke (18b) zugeordnet ist.

5. Positioniereinrichtung (5) nach Anspruch 4, **dadurch gekennzeichnet, dass** sie mindestens eine dritte Achse aufweist, die quer und insbesondere orthogonal zur ersten Achse und zur zweiten Achse verläuft, dass die Projektionseinrichtung (17) zur Projektion einer dritten Linie (23c) ausgestaltet ist, die parallel zu der dritten Achse verläuft, und dass der dritten Linie (23c) an dem ersten Vorrichtungsteil (7) vorzugsweise mindestens eine dritte Referenzmarke (18c) zugeordnet ist.

6. Positioniereinrichtung (5) nach einem der Ansprüche 1 bis 5 , **dadurch gekennzeichnet, dass** die Aufnahme (13) lösbar mit dem zweiten Vorrichtungsteil (8) verbunden ist und vorzugsweise an einer elektrisch gegen das zweite Vorrichtungsteil (8) isolierten Elektrodenplatte (12) angeordnet ist, die eine Durchgangslochung für den Ionenstrahl (3) aufweist.

7. Positioniereinrichtung (5) nach einem der Ansprüche 1 bis 6, **dadurch gekennzeichnet, dass** die mindestens eine Referenzmarke (18a, 18b, 18c) an einem lösbar mit dem ersten Vorrichtungsteil (7) verbindbaren Trägerteil (16) angeordnet ist, und dass das Trägerteil (16) derart ausgestaltet ist, dass er mit dem ersten Vorrichtungsteil (7) verbindbar und von diesem trennbar ist, während die Elektrodenplatte (12) an dem ersten Vorrichtungsteil (7) angeordnet ist.

8. Positioniereinrichtung (5) nach einem der Ansprüche 1 bis 7, **dadurch gekennzeichnet, dass** zur Ansteuerung des mindestens eines Positionierantriebs (10a, 10b, 10c) eine mobile Ansteuereinrichtung (24) vorgesehen ist, die über eine elektrische Steckverbindung 25) lösbar mit dem mindestens einen Positionierantrieb (10a, 10b, 10c) verbindbar ist, und dass die Ansteuereinrichtung (24) mindestens ein Betätigungselement (26a, 26b, 26c) für den Positionierantrieb (10a, 10b, 10c) aufweist.

9. Positioniereinrichtung (5) nach einem der Ansprüche 1 bis 8, **dadurch gekennzeichnet, dass** sie zur Erfassung der Position des mindestens einen Positionierantriebs (10a, 10b, 10c) wenigstens einen Lagesensor (27a, 27b, 27c) aufweist, und dass die Ansteuereinrichtung (24) mindestens eine damit verbundene Positionsanzeige (28a, 28b, 28c) hat.

10. Ionen-Implantationsanlage (1) mit einer Positioniereinrichtung (5) nach einem der Ansprüche 1 bis 9, **dadurch gekennzeichnet, dass** die Positioniereinrichtung (5) zur Erfassung der Position des mindestens einen Positionierantriebs (10a, 10b, 10c) wenigstens einen Lagesensor (27a, 27b, 27c) mit einem Ausgangsanschluss (34a, 34b, 34c) für ein erstes Lagemesssignal aufweist, der über eine Kompensationseinrichtung (32a, 32b, 32c) und einen Lageregler mit dem mindestens einen Positionierantrieb (10a, 10b, 10c) verbunden ist, dass die Kompensationseinrichtung (32a, 32b, 32c) einen mit dem Lagesensor (27a, 27b, 27c) verbundenen Eingang für das erste Lagemesssignal und einen mit einem Istwerteingang des Lagereglers verbundenen Ausgang (35a, 35b, 35c) für ein zweites Lagemesssignal hat, und dass die Kompensationseinrichtung (32a, 32b, 32c) derart ausgestaltet ist, dass sie das zweite Lagemesssignal in Abhängigkeit von dem ersten Lagemesssignal und mindestens einem die Bahnkurve des Ionenstrahls (3) beeinflussenden maschinenspezifischen Parameter der Ionen-Implantationsanlage (3) bereitstellt.

11. Ionen-Implantationsanlage (1) nach Anspruch 10, **dadurch gekennzeichnet, dass** der wenigstens eine Lagesensor (27a, 27b, 27c) über eine Steckkupplung mit dem Lageregler verbunden ist, dass die Steckkupplung ein erstes Steckkupplungsteil und ein dazu passendes zweites Steckkupplungsteil aufweist, und dass die Kompensationseinrichtung (32a, 32b, 32c) als zwischen die Steckkupplungsteile einsetzbarer Adapter ausgestaltet ist, der ein mit dem ersten Steckkupplungsteil verbindbares drittes Steckkupplungsteil (36) und ein mit dem zweiten Steckkupplungsteil verbindbares viertes Steckkupplungsteil (37) aufweist.

12. Ionen-Implantationsanlage (1) nach Anspruch 10 oder 11, **dadurch gekennzeichnet, dass** die Kompensationseinrichtung (32a, 32b,32c) mindestens ein Stellelement aufweist, mittels dem die Übertragungsfunktion zwischen dem ersten und dem zweiten Lagemesssignal einstellbar ist.

## Claims

1. Positioning device (5) for positioning an aperture (4) in an ion beam (3) in an ion implantation system (1), wherein the positioning device (5) has two apparatus parts (7, 8), which can be moved relative to one another by means of at least one positioning drive (10a, 10b, 10c) and one of which can be connected or is connected to an abutment point (9) arranged fixedly with respect to an ion beam source and the other of which can be connected or is connected to the aperture (4), wherein an adjustment device having a movement device and a display device is provided, wherein the movement device can be used to change the position of at least one of the apparatus parts (7, 8) relative to the positioning drive (10a, 10b, 10c), wherein the display device can be used to check whether the apparatus parts (7, 8) have a predetermined orientation relative to one another, and wherein the display device on the first apparatus part (7) or a part which is fixedly connected thereto has at least one reference mark (18a, 18b), **characterized in that** the display device on the second apparatus part (8) has at least one optical projection device (17) by means of which at least one optical marking can be projected onto the first apparatus part (7), which marking is associated with the at least one reference mark (18a, 18b).

2. Positioning device (5) according to Claim 1, **characterized in that** the aperture (4) can be connected releasably to a holder (13) which is provided on the second apparatus part (8) and **in that** the projection device (17) is designed such that it can be connected to the holder (13) instead of the aperture (4).

3. Positioning device (5) according to Claim 1 or 2, **characterized in that** the holder (13) has at least one guide rail (14) preferably for a dovetail guide, and **in that** the aperture (4) and the projection device (17) are arranged on a carriage part which matches the guide rail (14), can be fitted onto the guide rail (14) and removed from it, or are designed as such a carriage part.

4. Positioning device (5) according to one of Claims 1 to 3, **characterized in that** the projection device (17) is designed for the projection of at least two preferably intersecting lines (23a, 23b, 23c), which are arranged transversely with respect to one another and are continuous and/or interrupted, **in that** a first line (23a) is approximately parallel to a first axis of the positioning device (5) and a second line (23b) is approximately parallel to a second axis of the positioning device (5), and **in that** preferably at least one first reference mark (18a) is associated with the first line (23a) on the first apparatus part (7) and preferably at least one second reference mark (18b) is associated with the second line (23b).

5. Positioning device (5) according to Claim 4, **characterized in that** it has at least a third axis which extends transversely and in particular orthogonally with respect to the first axis and to the second axis, **in that** the projection device (17) is designed for the projection of a third line (23c) which extends parallel to the third axis, and **in that** preferably at least one third reference mark (18c) is associated with the third line (23c) on the first apparatus part (7).

6. Positioning device (5) according to one of Claims 1 to 5, **characterized in that** the holder (13) is connected releasably to the second apparatus part (8) and is preferably arranged on an electrode plate (12) which is electrically insulated with respect to the second apparatus part (8) and has a through-hole for the ion beam (3).

7. Positioning device (5) according to one of Claims 1 to 6, **characterized in that** the at least one reference mark (18a, 18b, 18c) is arranged on a support part (16) which can be connected releasably to the first apparatus part (7), and **in that** the support part (16) is designed such that it can be connected to the first apparatus part (7) and separated therefrom, while the electrode plate (12) is arranged on the first apparatus part (7).

8. Positioning device (5) according to one of Claims 1 to 7, **characterized in that** a mobile drive device (24), which can be connected releasably to the at least one positioning drive (10a, 10b, 10c) via an electric plug-in connection (25), is provided for driving the at least one positioning drive (10a, 10b, 10c), and **in that** the drive device (24) has at least one actuation element (26a, 26b, 26c) for the positioning drive (10a, 10b, 10c).

9. Positioning device (5) according to one of Claims 1 to 8, **characterized in that** it has at least one orientation sensor (27a, 27b, 27c) for detecting the position of the at least one positioning drive (10a, 10b, 10c), and **in that** the drive device (24) has at least one position display (28a, 28b, 28c) which is connected thereto.

10. Ion implantation system (1) having a positioning device (5) according to one of Claims 1 to 9, **characterized in that** the positioning device (5) has at least one orientation sensor (27a, 27b, 27c), for detecting the position of the at least one positioning drive (10a, 10b, 10c), with an output connector (34a, 34b, 34c) for a first orientation measurement signal, which orientation sensor is connected to the at least one positioning drive (10a, 10b, 10c) via a compensation device (32a, 32b, 32c) and an orientation regulator, **in that** the compensation device (32a, 32b, 32c) has an input, connected to the orientation sensor (27a, 27b, 27c), for the first orientation measurement signal and an output (35a, 35b, 35c), connected to an actual value input of the orientation regulator, for a second orientation measurement signal, and **in that** the compensation device (32a, 32b, 32c) is designed such that it provides the second orientation measurement signal as a function of the first orientation measurement signal and of at least one machine-specific parameter, which influences the path curve of the ion beam (3), of the ion implantation system (3).

11. Ion implantation system (1) according to Claim 10, **characterized in that** the at least one orientation sensor (27a, 27b, 27c) is connected to the orientation regulator via a plug-in coupling, **in that** the plug-in coupling has a first plug-in coupling part and a matching second plug-in coupling part, and **in that** the compensation device (32a, 32b, 32c) is designed in the form of an adapter which can be inserted between the plug-in coupling parts and which has a third plug-in coupling part (36), which can be connected to the first plug-in coupling part, and a fourth plug-in coupling part (37), which can be connected to the second plug-in coupling part.

12. Ion implantation system (1) according to Claim 10 or 11, **characterized in that** the compensation device (32a, 32b, 32c) has at least one actuator, which can be used to adjust the transmission function between the first and the second orientation measurement signal.

## Revendications

1. Dispositif de positionnement (5) destiné au positionnement d'un diaphragme (4) dans un faisceau d'ions (3) d'une installation d'implantation ionique (1), le dispositif de positionnement (5) étant doté de deux parties de dispositif (7, 8) réglables l'une par rapport à l'autre à l'aide d'au moins un entraînement de positionnement (10a, 10b, 10c), parmi lesquelles la première est reliée ou peut être reliée à une position de contre-palier (9) disposée fixement par rapport à une source de faisceau d'ions et l'autre est reliée ou peut être reliée au diaphragme (4), un dispositif d'ajustement étant doté d'un dispositif de réglage et d'un dispositif d'affichage, la position d'au moins une des parties de dispositif (7, 8) pouvant être modifiée par rapport à l'entraînement de positionnement (10a, 10b, 10c) à l'aide du dispositif de réglage, le dispositif d'affichage permettant de vérifier si les parties de dispositif (7, 8) se trouvent dans une position prédéfinie l'une par rapport à l'autre et le dispositif d'affichage comportant au moins une marque de référence (18a, 18b) au niveau de la première partie de dispositif (7) ou d'une partie fixement reliée à elle, **caractérisé en ce que** le dispositif d'affichage comporte au moins un dispositif de projection (17) optique au niveau de la deuxième partie de dispositif (8), ledit dispositif de projection pouvant être projeté à l'aide d'au moins un marquage optique positionné sur la première partie de dispositif (7), ledit marquage étant associé au moins à une marque de référence (18a, 18b).

2. Dispositif de positionnement (5) selon la revendication 1, **caractérisé en ce que** le diaphragme (4) peut être relié de façon amovible à un logement (13) prévu au niveau de la deuxième partie de dispositif (8) et que le dispositif de projection (17) est réalisé de telle sorte qu'il peut être relié au logement (13) à la place du diaphragme (4).

3. Dispositif de positionnement (5) selon la revendication 1 ou 2, **caractérisé en ce que** le logement (13) comporte au moins un rail de guidage (14) prenant de préférence la forme d'un guide en queue d'aronde et que le diaphragme (4) et le dispositif de projection (17) peuvent être disposés au niveau d'une partie de coulisseau adaptée au rail de guidage (14), enfichable sur le rail de guidage (14) et retirable de celui-ci ou sont réalisés sous la forme d'une telle partie de coulisseau.

4. Dispositif de positionnement (5) selon l'une quelconque des revendications 1 à 3, **caractérisé en ce que** le dispositif de projection (17) est réalisé pour la projection d'au moins deux lignes (23a, 23b, 23c) disposées perpendiculairement l'une par rapport à l'autre, se croisant de préférence et/ou s'interrompant, qu'une première ligne (23a) s'étend approximativement parallèlement à un premier axe du dispositif de positionnement (5) et qu'une deuxième ligne (23b) s'étend approximativement parallèlement à un deuxième axe du dispositif de positionnement (5) et que la première ligne (23a) est associée au moins au niveau de la première partie de dispositif (7) de préférence à au moins à une première marque de référence (18a) et que la deuxième ligne (23b) est associée de préférence au moins à une deuxième marque de référence (18b).

5. Dispositif de positionnement (5) selon la revendication 4, **caractérisé en ce qu'**il comporte au moins un troisième axe s'étendant transversalement et notamment perpendiculairement au premier axe et au deuxième axe, que le dispositif de projection (17) est réalisé pour la projection d'une troisième ligne (23c) s'étendant parallèlement au troisième axe et que la troisième ligne (23c) est associée au niveau de la première partie de dispositif (7) de préférence au moins à une troisième marque de référence (18c).

6. Dispositif de positionnement (5) selon l'une quelconque des revendications 1 à 5, **caractérisé en ce que** le logement (13) est relié de façon amovible à la deuxième partie de dispositif (8) et disposé de préférence au niveau d'une plaque d'électrode (12) isolée sur le plan électrique par rapport à la deuxième partie de dispositif (8), ladite plaque comportant un trou de passage pour le faisceau d'ions (3).

7. Dispositif de positionnement (5) selon l'une quelconque des revendications 1 à 6, **caractérisé en ce que** l'au moins une marque de référence (18a, 18b, 18c) est disposée de façon à pouvoir être reliée à une partie de support (16) pouvant être reliée de façon amovible à la première partie de dispositif (7) et que la partie de support (16) est réalisée de telle sorte qu'elle peut être reliée à la première partie de dispositif (7) et séparée d'elle lorsque la plaque d'électrode (12) est disposée sur la première partie de dispositif (7).

8. Dispositif de positionnement (5) selon l'une quelconque des revendications 1 à 7, **caractérisé en ce qu'**un dispositif de commande (24) mobile est prévu pour commander l'au moins un entraînement de positionnement (10a, 10b, 10c), ledit dispositif de commande pouvant être relié de façon amovible à l'au moins un entraînement de positionnement (10a, 10b, 10c) par l'intermédiaire d'une jonction électrique enfichable (25) et que le dispositif de commande (24) comporte au moins un élément d'entraînement (26a, 26b, 26c) pour l'entraînement de positionnement (10a, 10b, 10c).

9. Dispositif de positionnement (5) selon l'une quelconque des revendications 1 à 8, **caractérisé en ce qu'**il comporte au moins un capteur de position (27a, 27b, 27c) pour détecter la position de l'au moins un entraînement de positionnement (10a, 10b, 10c) et que le dispositif de commande (24) comporte au moins un indicateur de position (28a, 28b, 28c) relié à lui.

10. Installation d'implantation ionique (1) dotée d'un dispositif de positionnement (5) selon l'une quelconque des revendications 1 à 9, **caractérisée en ce que** le dispositif de positionnement (5) comporte au moins un capteur de position (27a, 27b, 27c) pour détecter la position de l'au moins un entraînement de positionnement (10a, 10b, 10c) avec un raccord de sortie (34a, 34b, 34c) pour un premier signal de mesure de position, ledit raccord étant relié à l'au moins un entraînement de positionnement (10a, 10b, 10c) par l'intermédiaire d'un dispositif de compensation (32a, 32b, 32c) et d'un régulateur de position, que le dispositif de compensation (32a, 32b, 32c) a une entrée reliée au capteur de position (27a, 27b, 27c) pour le premier signal de mesure de position et une sortie reliée à une entrée de valeur réelle (35a, 35b, 35c) du régulateur de position pour un deuxième signal de mesure de position et que le dispositif de compensation (32a, 32b, 32c) est réalisé de telle sorte qu'il met à disposition le deuxième signal de mesure de position en fonction du premier signal de mesure de position et d'au moins un paramètre de l'installation d'implantation ionique (3) spécifique à la machine influant sur la courbe de trajectoire du faisceau d'ions (3).

11. Installation d'implantation ionique (1) selon la revendication 10, **caractérisée en ce que** l'au moins un capteur de position (27a, 27b, 27c) est relié au régulateur de position via un couplage enfichable, que le couplage enfichable comporte une première partie de couplage enfichable et une deuxième partie de couplage enfichable adaptée à elle et que le dispositif de compensation (32a, 32b, 32c) prend la forme d'un adaptateur pouvant être inséré entre les parties de couplage enfichable et comportant une troisième partie de couplage enfichable (36) pouvant être reliée à la première partie de couplage enfichable et une quatrième partie de couplage enfichable (37) pouvant être reliée à la deuxième partie de couplage enfichable.

12. Installation d'implantation ionique (1) selon la revendication 10 ou 11, **caractérisée en ce que** le dispositif de compensation (32a, 32b, 32c) comporte au moins un élément de réglage à l'aide duquel la fonction de transmission peut être réglée entre le premier et le deuxième signal de mesure de position.
